(19) Europäisches Patentamt
European Patent Office
Office européen des brevets

(11) EP 2 133 922 A2

(12) # EUROPEAN PATENT APPLICATION

(43) Date of publication:
**16.12.2009 Bulletin 2009/51**

(21) Application number: **09162118.5**

(22) Date of filing: **05.06.2009**

(51) Int Cl.:
***H01L 31/032*** *(2006.01)* ***H01L 31/18*** *(2006.01)*
***H01L 31/02*** *(2006.01)*

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **12.06.2008 US 138001**

(71) Applicant: **General Electric Company**
**Schenectady, NY 12345 (US)**

(72) Inventors:
- **Korevaar, Bastiaan Arie**
  **Schenectady, NY 12305 (US)**
- **Johnson, James Neil**
  **Scotia, NY 12302 (US)**
- **Miebach, Thomas**
  **Ballston Spa, NY 12020 (US)**
- **Blaydes, Holly Ann**
  **Burnt Hills, NY 12027 (US)**
- **Pickett, James Edward**
  **Schenectady, NY 12304 (US)**

(74) Representative: **Szary, Anne Catherine**
**GE International Inc.**
**Global Patent Operation - Europe**
**15 John Adam Street**
**London**
**WC2N 6LU (GB)**

(54) **Insulating coating, methods of manufacture thereof and articles comprising the same**

(57) Disclosed herein is an article comprising a metallic substrate 10; an insulating layer 20; the insulating layer 20 being disposed on the metallic substrate 10 in an expanding thermal plasma; and a semiconductor layer 40; the semiconductor layer 40 being disposed on the insulating layer 20. Disclosed herein too is a method comprising disposing an insulating layer 20 on a metallic substrate; the insulating layer 20 being in intimate contact with the metallic layer; wherein the insulating layer 20 is derived from a metal-organic precursor, and wherein insulating layer 20 is deposited in an expanding thermal plasma; and disposing a semiconductor layer 40 on the insulating layer.

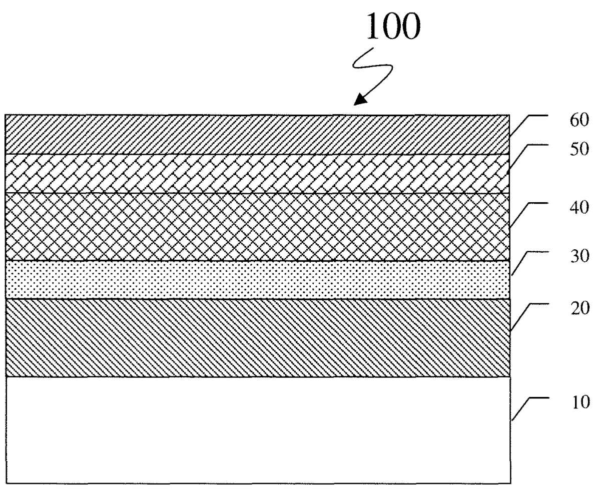


Figure



Printed by Jouve, 75001 PARIS (FR)

## Description

BACKGROUND

This disclosure relates to an insulating coating, methods of manufacture thereof and articles comprising the same.

Photovoltaic devices, i.e., solar cells, are capable of converting solar radiation into usable electrical energy. The energy conversion occurs as the result of what is known as the photovoltaic effect. Solar radiation impinging on a solar cell and absorbed by an active region of a semiconductor material generates electricity. Since each cell itself generates only a small amount of power, the desired voltage and/or current is achieved by interconnecting discrete cells in series or in parallel arrays. To provide the desired voltage or current, an array can include hundreds or thousands of cells.

Modules with a large number of solar cells use a large number of electrical interconnections. Ideally, the interconnection process would be integrated with the cell manufacturing process, i.e. "monolithically integrated," so that connecting solar cells are not unduly costly or cumbersome.

Commercially available solar cells employ a photoactive material on an insulating substrate such as glass or plastic. Glass substrates are insulating and facilitate the formation of monolithic solar cells on glass substrates. Glass substrates can also sustain high temperatures and are therefore compatible with high temperature, low cost manufacturing methods to form semiconductor layers, such as those that comprise $CuIn_xGa_{(1-x)}Se_2$ (CIGS) or CdTe. However, glass substrates are not flexible and prone to fracture thereby limiting their commercial applicability. Plastic substrates have also been considered for use in solar cells. Plastic substrates are flexible and insulating, and can also enable the monolithic integration of solar cells, but have limited ability to withstand high temperatures, thus precluding their use in manufacturing processes that involve high temperatures.

It is therefore desirable to have a solar cell substrate that is insulating, can sustain high temperatures, and that is mechanically flexible.

BRIEF SUMMARY

Disclosed herein is an article comprising a metallic substrate; an insulating layer; the insulating layer being disposed on the metallic layer in an expanding thermal plasma; and a semiconductor layer; the semiconductor layer being disposed on the insulating layer.

Disclosed herein too is a method comprising disposing an insulating layer on a metallic substrate; the insulating layer being in intimate contact with the metallic layer; wherein the insulating layer is derived from a metal-organic precursor, and wherein insulating layer is deposited in an expanding thermal plasma; and disposing a semiconductor layer on the insulating layer.

These and other features, aspects, and advantages of the disclosed embodiments will become better understood with reference to the following description and appended claims.

BRIEF DESCRIPTION OF THE DRAWINGS

The disclosed subject matter is particularly pointed out and distinctly claimed in the claims at the conclusion of the specification. The foregoing and other objects, features, and advantages of the disclosed embodiments are apparent from the following detailed description taken in conjunction with the accompanying drawing, by way of example, in which Figure 1 is a schematic, sectional view of a solar cell fabricated on a flexible metallic substrate.

The detailed description explains the preferred embodiments, together with advantages and features, by way of example with reference to the drawings.

DETAILED DESCRIPTION

The terms "the", "a" and "an" do not denote a limitation of quantity, but rather denote the presence of at least one of the referenced item. The suffix "(s)" as used herein is intended to include both the singular and the plural of the term that it modifies, thereby including at least one of that term (e.g., the colorant(s) includes at least one colorants).

Unless defined otherwise, technical and scientific terms used herein have the same meaning as is commonly understood by one of skill in the art.

As used herein, the terms "first," "second." and the like do not denote any order or importance, but rather are used to distinguish one element from another.

As used herein, approximating language can be applied to modify any quantitative representation that can vary without resulting in a change in the basic function to which it is related. Accordingly, a value modified by a term or terms, such as "about" and "substantially," cannot be limited to the precise value specified, in some cases. In at least some

instances, the approximating language can correspond to the precision of an instrument for measuring the value. Thus the modifier "about" used in connection with a quantity is inclusive of the stated value and has the meaning dictated by the context (e.g., includes the degree of error associated with measurement of the particular quantity).

The notation "± 10%" means that the indicated measurement can be from an amount that is minus 10% to an amount that is plus 10% of the stated value. Furthermore, all ranges disclosed herein are inclusive of the endpoints and are independently combinable. The endpoints of all ranges directed to the same component or property are inclusive and independently combinable (e.g., ranges of "less than or equal to about 25 wt%, or, more specifically, about 5 wt% to about 20 wt%," is inclusive of the endpoints and all intermediate values of the ranges of "about 5 wt% to about 25 wt%," etc.).

"Optional" or "optionally" means that the subsequently described event or circumstance can or can not occur, and that the description includes instances where the event occurs and instances where it does not. All cited patents, patent applications, and other references are incorporated herein by reference in their entirety As used herein, "substrate" or "substrates" can be used interchangeably with "surface" or "surfaces."

Disclosed herein is an article that comprises an adherent insulating layer disposed on and in intimate contact with a metallic substrate. The metallic substrate provides the mechanical flexibility and stability against high process temperatures desired in the photovoltaic cell while the insulating layer enables monolithic integration of the devices on metallic substrates. The article can further comprise a contact layer, a semiconductor layer, a window layer, an intrinsic conducting oxide layer, and a transparent conducting oxide (TCO) layer if desired. The article may further comprise other functional coatings that are disposed on the substrate (e.g., diffusion barriers).

The article can advantageously be used in photovoltaic cells and solar cells. The insulating layer enables the manufacture of monolithically integrated solar cells because it forms adherent, insulating films on metallic substrates, and because substrates with the insulating layer can sustain the high temperatures that are desirably used in solar cell manufacture. The disclosed insulating layer is particularly advantageous because it can be formed at high rates. High rate deposition enables the formation of an insulating layer of the desired thickness in a short time, enabling reduction in the cost of solar cell components.

The insulating layer provides excellent adhesion to metallic substrates, in particular stainless steel, enabling the use of flexible metallic substrates, such as stainless steel foil, as substrates for solar cells. In addition, because the disclosed insulating layer can be formed on metallic substrates, and because the insulating layer is chemically stable at high temperature, the insulating layer can be annealed after deposition, thus greatly reducing or entirely eliminating errors in the insulating layer.

With reference now to the Figure, the article 100 comprises a metallic substrate (10), an insulating layer (20), a contact layer (30), a semiconductor layer (40), a window layer (50) and a transparent conducting oxide (TCO) layer (60).

As noted above, the substrate comprises a metal. The metal can comprise aluminum, iron, molybdenum, tungsten, vanadium, rhodium, niobium, chromium, tantalum, titanium, steel, brass, bronze, tin, copper, zinc, nickel, platinum, silver, gold, or the like, or a combination comprising at least one of the foregoing metals. In an exemplary embodiment, the metal is stainless steel. The metallic substrate can have a thickness of about 10 to about 1,000 micrometers, specifically about 10 to about 500 micrometers, and more specifically about 25 to about 100 micrometers.

In an exemplary embodiment, the insulating layer is disposed on and in intimate contact with the metallic layer. The insulating layer can be derived from a metal-organic precursor. The metal-organic precursor can be linear or cyclic. The metal in the metal-organic precursor can be silicon, germanium, tin, titanium or lead.

In one embodiment, the metal-organic precursors are organosilicon compounds. The organosilicon compounds generally used in the manufacturing of the insulating layer can have a silicon atom that is bonded to at least one carbon atom and include, for example, silanes, siloxanes and silazanes. These organosilicon compounds may be used individually or in combinations of two or more. These organosilicon compounds may be linear or cyclic organosilicon compounds. Combinations of linear and cyclic organosilicon compounds can be used.

Organosilicon compounds are represented by the general formula (1):

$$R^1{}_nSiZ_{(4-n)} \qquad (1)$$

wherein $R^1$ represents a monovalent hydrocarbon radical or a halogenated monovalent hydrocarbon radical, Z represents a hydrolyzable group, and n may vary between 0 and 2. In one embodiment, Z can be a halogen, alkoxy, acyloxy, or aryloxy. Such compounds are described, for example, in U.S. Pat. No. 4,224,378 to Schroeter et al., the entire contents of which are hereby incorporated by reference.

Other exemplary organosilicon include silanols having the general formula (2):

$$R^2Si(OH)_3 \qquad (2)$$

wherein $R^2$ is selected from the group consisting of an alkyl radical comprising about 1 to about 3 carbon atoms, a vinyl radical, a 3,3,3-trifluoropropyl radical, a gamma-glycidoxypropyl radical and a gamma-methacryloxypropyl radical, with at least about 70% by weight of the silanol being $CH_3Si(OH)_3$. Such compounds are also described in U.S. Pat. No. 4,242,381, to Schroeter et al., the entire contents of which are hereby incorporated by reference.

Examples of linear silanes include dimethoxydimethylsilane, methyltrimethoxysilane, tetramethoxysilane, ethyltrimethoxysilane, diethoxydimethylsilane, methyltriethoxysilane, triethoxyvinylsilane, tetraethoxysilane, dimethoxymethylphenylsilane, phenyltrimethoxysilane, 3-glycidoxypropyltrimethoxysilane, 3-methacryloxypropyltrimthoxysilane, diethoxymethylphenylsilane, tris(2-methoxyethoxy)vinylsilane, phenyltriethoxysilane, dimethoxydiphenylsilane, or the like, or a combination comprising at least one of the foregoing silanes. An example of a cyclic silane is octamethylcyclotetrasilane.

Examples of linear siloxanes include tetramethyldisiloxane (TMDSO), hexamethyldisiloxane (HMDSO), or the like, or a combination comprising at least one of the foregoing siloxanes.

In one embodiment, the metal-organic precursor can be a cyclosiloxane. In one embodiment, the cyclosiloxane can be unsubstituted. In another embodiment the cyclosiloxane can be organo-substituted with one or more lower alkyl groups of $C_1$, to $C_3$, i.e. the cyclosiloxane can be substituted with one or more methyl, ethyl, propyl and/or isopropyl groups, or the like, or a combination comprising at least one of the foregoing groups. In an embodiment, the cyclosiloxane is a cyclic trimer (or cyclotrisiloxane); a cyclic tetramer (or cyclotetrasiloxane); or a cyclic pentamer (or cyclopentasiloxane), or the like, or a combination comprising at least one of the foregoing cyclosiloxanes. In one embodiment, at least one alkenyl group may be attached directly to a silicon atom of the cyclosiloxane. In an exemplary embodiment, only one such alkenyl group is so attached. For embodiments where the alkenyl group has 3 or more carbon atoms, the double bond can be located anywhere in the moiety. In another embodiment, the alkenyl group in this regard has a terminal carbon-carbon double bond. Examples of alkenyl groups include vinyl, allyl, hexenyl and the like.

An exemplary cyclosiloxane has the structure of formula (3):

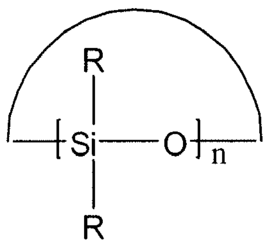

(3)

wherein each R can be the same or different and is independently hydrogen, methyl, ethyl or propyl, and n is an integer from 2 to 8.

Examples of silazanes include hexamethyldisilazane, tetramethyldisilazane, or a combination comprising at least one of the foregoing silazanes.

An exemplary organosilicon compound used in the production of the insulating layer is octamethylcyclotetrasiloxane ($D_4$).

In one embodiment, the insulating layer can be disposed on the metallic substrate by a process that involves the use of a plasma. The insulating layer can be disposed using a vapor phase, if desired. Examples of suitable deposition processes include expanding thermal plasma (ETP), ion plating, plasma enhanced chemical vapor deposition (PECVD), metal organic chemical vapor deposition (MOCVD) (also called Organometallic Chemical Vapor Deposition (OMCVD)), metal organic vapor phase epitaxy (MOVPE), physical vapor deposition processes such as sputtering, reactive electron beam (e-beam) deposition, or the like, or a thermal spray processes, the thermal spray process comprising plasma spraying, expanding plasma spraying, flame spraying, arc spraying, DC-arc plasma spraying, RF induction plasma spraying, or wire-arc spraying, or the like, or a combination comprising at least one of the foregoing processes. An exemplary process is ETP.

In an exemplary embodiment, the insulating layer is disposed via ETP. By using ETP, high deposition rates can be achieved at relatively low temperatures.

Furthermore, the insulating layer can be applied to large areas of the metallic substrate in a single operation. The insulating layer can comprise a single layer that is applied in a single step or in multiple steps if desired. Both sides

of the substrate can be coated simultaneously if desired. Multiple sets of plasma generators can be used to increase deposition rate and/or the area of coverage. The ETP process can be carried out in a single deposition chamber or in a plurality of deposition chambers.

ETP methods that can be used for applying the insulating layer are described in U.S. Pat. No. 6,110,544 to Yang et al., 6,261,694 to Iacovangelo, and U.S. Pat. No. 6,397,776 to Yang et al., the entire contents of which are hereby incorporated by reference. In one embodiment, a precursor is introduced into an ETP and a plasma stream produced by the ETP is disposed upon the surface of the substrate. Prior to applying the insulating layer, the metallic substrate can be etched if desired. In one embodiment, the metallic substrate is first heated to the desired temperature following which the insulating layer is disposed upon the substrate.

The use of ETP permits the rapid deposition of an insulating layer when compared with other techniques such as sputtering or PECVD. In one embodiment, the insulating layer can be deposited at a rate of greater than or equal to about 0.1 micrometer per minute. Alternatively, the insulating layer can be deposited at a rate of greater than or equal to about 5 micrometers per minute, specifically at a rate of greater than or equal to about 10 micrometers per minute, and more specifically at a rate of greater than or equal to about 100 micrometers per minute. In one embodiment the insulating layer is deposited at a rate of about 0.1 to 100 micrometers per minute. The insulating layer can have a thickness of about 1 to about 100 micrometers, specifically about 2 to about 50 micrometers, and more specifically about 5 to about 20 micrometers. In an exemplary embodiment, the insulating layer has a thickness of about 10 micrometers.

In an embodiment, the insulating layer is deposited at a temperature of about room temperature to about 800°C, specifically at about 100 to about 650°C, and more specifically at about 200 to about 300°C. In an exemplary embodiment, the insulating layer is deposited at about 150 to about 250°C.

In an exemplary embodiment, the insulating layer can comprise a silicon dioxide, a silicon oxycarbide, a titanium dioxide, or the like, or a combination comprising at least one of the foregoing. A insulating layer having the formula $SiO_xC_yH_z$ can be used as the insulating layer, where x, y and z are each about 0.001 to about 2, specifically about 0.01 to about 0.9, and more specifically about 0.1 to about 0.5. In one embodiment, x is about 1.8, y is about 0.4 and z is about 0.07.

In one embodiment, the insulating layer is substantially amorphous. The insulating layer can have an amorphous content of about 10 to about 90 weight percent (wt %), based upon the total weight of the insulating layer. In a second embodiment, the insulating layer is completely amorphous.

After the insulating layer is disposed on the metallic substrate, the insulating layer and metallic substrate can be optionally annealed if desired. The article comprising the insulating layer and metallic substrate are stable (e.g., the retain their insulating properties) at temperatures of greater than or equal to about 300°C, specifically temperatures of greater than or equal to about 400°C, and more specifically temperatures of greater than or equal to about 500°C or 550°C. In an embodiment, the article is stable at a temperature of greater than or equal to 600°C.

In one embodiment, a contact layer, a semiconductor layer, a window layer and a TCO layer can be disposed on the insulating layer to form a solar cell. The contact layer can comprise molybdenum, tungsten, copper, platinum, gold, or the like, or a combination comprising at least one of the foregoing metals.

The semiconductor layer can comprise various combinations of copper, indium, gallium, aluminum, sulfur, selenium. Examples of these combinations are $Cu(In,Ga,Al)(S,Se)_2$, $CuIn_xGa_{(1-x)}Se_2$ (CIGS), $CuInSe_2$ (CIS), CdTe, Silicon, a-Si:H, or the like, or a combination comprising at least one of the foregoing semiconductor materials, where x is 0 to 1. The semiconductor layer can be deposited by methods that include evaporation, sputtering, electrodeposition, chemical vapor deposition, sublimation, vapor transport deposition, physical vapor deposition, MOCVD, spray deposition, screen printing, or the like, or a combination comprising at least one of the foregoing methods.

The window layer can comprise elements of Groups II - VI. Examples of materials that can be used in the window layer are CdS, ZnSe, CdZnS, ZnO, $Zn(O,S,OH)_x$, ZnS, $In_xSe_y$, $In_xS_y$, or the like, or a combination comprising at least one of the foregoing Group II-VI materials to form a heterojunction with the semiconductor layer.

A TCO layer for collection of current is disposed on the window layer. The TCO layer can comprise zinc oxide (ZnO), or the like. In some instances an intrinsic transparent oxide (like intrinsic ZnO, $ZnSnO_4$, etc.) is used in between the CdS type layer and the TCO, such that the CdS type layer can be made thinner without causing shorting. A grid contact or other collector can be deposited on the upper surface of the TCO layer. The grid contact can be formed from various materials but should have high electrical conductivity and form a good ohmic contact with the underlying TCO. In an embodiment, the grid contact comprises a metal. The grid contact metal can be aluminum, indium, chromium, molybdenum, silver, titanium, copper, or the like, or a combination comprising at least one of the foregoing metals, and can comprise an additional conductive metal overlayment, the overlayment comprising copper, silver, nickel, or the like, or a combination comprising at least one of the foregoing metals.

Furthermore, one or more anti-reflective coatings (not shown) can be disposed on the solar cell to improve collection of incident light. In on embodiment, in order to improve anti-reflective properties, the surface of the TCO layer can be roughened with small scale texturing, such that additional anti-reflective coatings may not be desirable.

In one embodiment, scribing a solar cell can be used to form a monolithic solar cell that can comprise a plurality

of solar cells. In the scribing process, the contact, semiconductor, window and TCO layers are cut but the metallic substrate is left intact, the metallic substrate protected by the insulating layer. Thus the insulating layer can be scribed, partially scribed, or not scribed in the scribing process. In an embodiment the insulating layer is partially scribed in the scribing process. In this manner monolithically integrated solar cells can be economically formed on a flexible, mechanically robust substrate. The scribing can be performed by a mechanical method, thermal method, optical method, or the like, or a combination comprising at least one of the foregoing methods. An exemplary method of scribing is laser scribing. Scribing can be performed to leave the metallic substrate intact but divides the contact layer, semiconductor layer, window layer and TCO layer to form a plurality of solar cells. Thus after scribing adjacent solar cells are not in electrical communication and the solar cells are electrically isolated from the metallic substrate by the insulating layer but physically connected by the metallic substrate.

The insulating layer manufactured by the aforementioned processes, especially the expanding thermal plasma process has a number of advantages over other comparative insulating layers. The insulating layer permits or facilitates monolithic integration with the metallic substrate. The insulating layer described herein further acts as a better diffusion barrier to impurities from the metal substrate than any polymeric silicone (e.g., polydimethylsiloxane) based insulating layer. It can withstand higher annealing temperatures, needed for high quality CIS processing.

The insulating layers described herein are temperature resistant and can withstand temperatures of greater than or equal to about 300°C, specifically greater than or equal to about 400°C, specifically greater than or equal to about 500°C, and more specifically greater than or equal to about 600°C without any degradation. The insulating layer displays good adhesion to the metallic substrate and does not crack at these elevated temperatures. It also does not delaminate during laser scribing.

The expanding thermal plasma process has numerous advantages over other comparative processes such as plasma enhanced chemical vapor deposition for manufacturing the insulating layer. It is a quick throughput process and adds minimal additional cost to the manufacturing of the solar cell. The insulating layer produced by the expanding thermal plasma process is conformal, i.e., it conforms to any shape adopted by the metallic substrate. Other comparative insulating layers such as those that comprise polymeric silicones can have a thickness that is restricted by the height of the roughness of the layer. The insulating layers produced by ETP can be manufactured to be thinner than comparative insulating layers manufactured from a polymeric silicone.

The invention is further described by the following non-limiting examples.

## EXAMPLES

### Example 1

This example was conducted to demonstrate the stability of the insulating layer on a metallic substrate. The metallic substrate comprised metal casings manufactured from stainless steel. Silicon containing films having a thickness of 5 micrometers or 10 micrometers were deposited on the metal casing using an expanding thermal plasma. Octamethylcyclotetrasiloxane ($D_4$) is used as a precursor for the coatings.

Prior to deposition, the metal casings were cleaned with isopropyl alcohol, rinsed, and air dried. Substrates were loaded onto a rack in a load lock, pumped down to about 26 millitorr, preheated at 1000 watts for 10 seconds before being introduced into the expanding thermal plasma. The expanding thermal plasma uses an atmosphere comprising argon and oxygen in a volume ratio of 1:3. The argon is used to form the plasma. The octamethylcyclotetrasiloxane undergoes dissociation at the elevated temperatures of the expanding thermal plasma and combines with the oxygen in the plasma to form a silicon containing insulating layer. The thickness of the insulating layer was about 5 to about 10 micrometers depending on the number of layers deposited.

The metal casings with the insulating layer disposed thereon were heat treated at a temperature of 500°C for 30 minutes. No delamination or cracking was observed in the insulating layer after the heat treatment.

### Example 2

The metallic substrate in this example was a stainless steel foil. The stainless steel foil was treated in a similar manner to the metal casings of Example 1, prior to the deposition of the coating in the expanding thermal plasma. The method of depositing the insulating layer in this example was similar to that in the Example 1. The composition of the insulating layer in this example was similar to that in the Example 1. The stainless steel foil with the insulating layer disposed thereon were heat treated at a temperature of 500°C for 30 minutes. No delamination or cracking was observed in the insulating layer after the heat treatment.

Example 3

This example was conducted to determine the quality of a multilayered device, where one of the layers is the insulating layer disposed in an expanding thermal plasma as described above. The metallic substrate was a stainless steel foil similar to that in Example 2. The insulating layer was disposed on the stainless steel foil in a manner similar to that in Example 2. The thickness of the insulating layer was similar to that described in the Example 2. 500 nanometers of molybdenum were deposited on the insulating coating by sputtering.

The system used for the sputtering was a Perkin Elmer model 2400 Radio Frequency sputter coater. The type of sputtering is radio frequency (RF) planar deposition using a 6 inch circular molybdenum target (99.95% purity). Prior to deposition, the samples were degreased using Genesolve solvent, then ultrasonically cleaned in acetone followed by cleaning in methanol. The vacuum in the sputter coater prior to deposition was 4 x $10^{-7}$ torr. Target to substrate distance was 1 and 5/8 inches. The samples were coated in a 100% research grade argon environment at a run pressure of 9 millitorr. The insulating layer was plasma etched prior to deposition for 5 minutes at 100 watts. The molybdenum, layer was then deposited first at 200 watts for 5 minutes and then at 400 watts for approximately 35 minutes. The actual temperature was not measured. The estimated surface temperature is about 225°C during deposition. The multilayered device with the stainless steel foil, the insulating layer and the molybdenum layer disposed thereon was again heated to a temperature of 500°C for 30 minutes. No delamination or cracking occurred in the insulating layer and no shorting between the molybdenum layer and the stainless steel foil through the insulating layer.

Example 4

This example was conducted to determine the quality of a multilayered device, where one of the layers is the insulating layer disposed in an expanding thermal plasma as described above. The metallic substrate was a stainless steel foil similar to that in Example 2. The insulating layer was disposed on the stainless steel foil in a manner similar to that in Example 2. The thickness of the insulating layer was similar to that described in the Example 2. 500 nanometers of molybdenum were deposited on the insulating coating by sputtering. The molybdenum layer was disposed in a manner similar to that described in the Example 3. Following the deposition of the molybdenum layer, the multilayered device was coated with a layer of $CuIn_xG_{(1-x)}Se_2$ (CIGS) at 550°C. The $CuIn_xGa_{(1-x)}Se_2$ was deposited using the Institute of Energy Conversions baseline elemental evaporation process. For this process, the substrate temperature during the deposition is 550°C. No delamination or cracking occurred in the insulating layer or the molybdenum and no shorting between the molybdenum layer and the stainless steel foil through the insulating layer.

While the invention has been described with reference to exemplary embodiments, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment disclosed as the best mode contemplated for carrying out this invention.

## Claims

1. An article (100) comprising:

    a metallic substrate (10);
    an insulating layer (20); the insulating layer (20) being disposed on the metallic substrate (10) in an expanding thermal plasma; and
    a semiconductor layer (40); the semiconductor layer (40) being disposed on the insulating layer (20).

2. The article (100) of Claim 1, wherein a metal organic precursor is used in the plasma.

3. The article (100) of Claim 2, wherein the metal-organic precursor comprises silicon, germanium, titanium, lead or tin.

4. The article (100) of Claim 2 or Claim 3, wherein the metal-organic precursor has the structure of formula (1):

$$R^1_nSiZ_{(4-n)} \qquad (1)$$

wherein $R^1$ represents a monovalent hydrocarbon radical or a halogenated monovalent hydrocarbon radical, Z represents a hydrolyzable group, and n may vary between 0 and 2.

**5.** The article (100) of Claim 2, wherein the metal-organic precursor has the structure of formula (2):

$$R^2Si(OH)_3 \qquad (2)$$

wherein $R^2$ is selected from the group consisting of an alkyl radical comprising about 1 to about 3 carbon atoms, a vinyl radical, a 3,3,3-trifluoropropyl radical, a gamma-glycidoxypropyl radical and a gamma-methacryloxypropyl radical; or wherein the metal-organic precursor has the structure of formula (3):

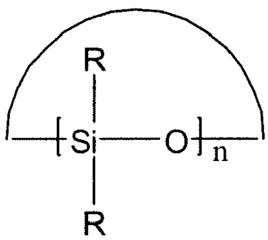

(3)

wherein each R can be the same or different and is independently hydrogen, methyl, ethyl or propyl; and n is an integer from 2 to 8.

**6.** The article (100) of Claim 2, wherein the metal-organic precursor is octamethylcyclotetrasiloxane.

**7.** The article (100) of any preceding Claim, wherein the insulating layer (20) has a thickness of about 1 to about 50 micrometers.

**8.** The article (100) of any preceding Claim, wherein the insulating layer (20) comprises silicon, titanium, tin, lead, or germanium.

**9.** The article (100) of any preceding Claim, wherein the insulating layer (20) has the formula $SiO_xC_yH_z$, where x, y and each have values of about 0.001 to about 2 respectively.

**10.** The article (100) of any preceding Claim, wherein the insulating layer (20) is conformal with the roughness of the metallic substrate (10).

**11.** The article (100) of any preceding Claim, wherein the metallic substrate (10) comprises aluminum, iron, molybdenum, tungsten, vanadium, rhodium, niobium, chromium, tantalum, titanium, steel, brass, bronze, tin, copper, zinc, nickel, platinum, silver, gold, or a combination comprising at least one of the foregoing metals.

**12.** The article (100) of any preceding Claim, wherein the metallic substrate (10) has a thickness of 10 to 1,000 micrometers.

**13.** The article (100) of any preceding Claim, wherein the article is a solar cell.

**14.** A method comprising:

disposing an insulating layer (20) on a metallic substrate (10); the insulating layer (20) being in intimate contact with the metallic substrate (10); wherein the insulating layer (20) is derived from a metal-organic precursor, and wherein insulating layer (20) is deposited in an expanding thermal plasma; and
disposing a semiconductor layer (40) on the insulating layer (20).

**15.** The method of Claim 14, wherein insulating layer (20)is deposited using a vapor phase.

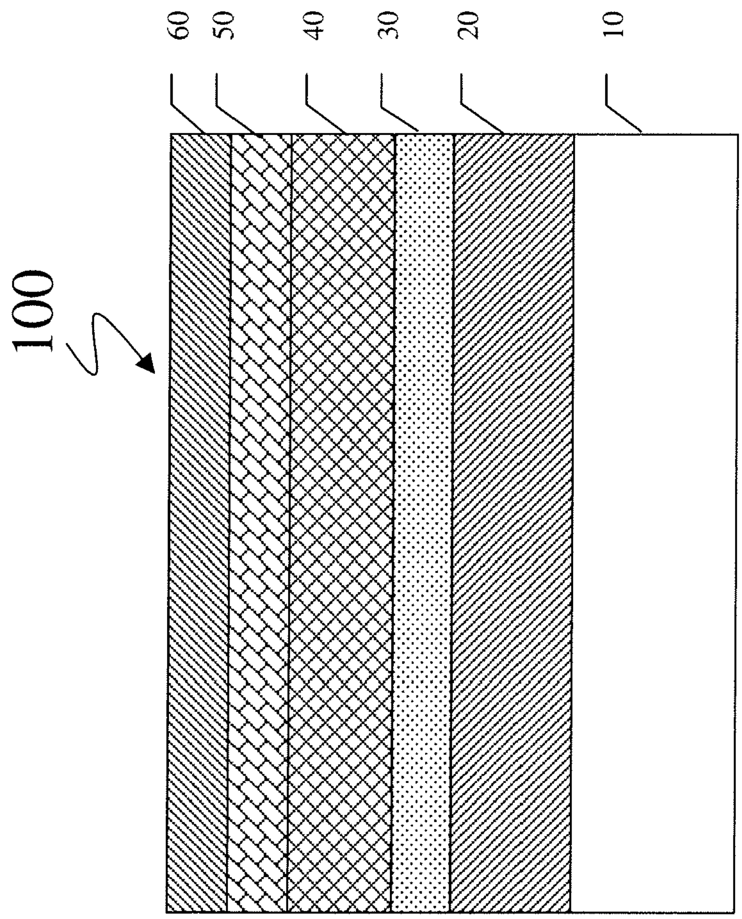


Figure

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 4224378 A, Schroeter
- US 4242381 A, Schroeter
- US 6110544 A, Yang
- US 6261694 A, Iacovangelo
- US 6397776 B, Yang